# EUROPÄISCHE PATENTSCHRIFT

(11) **EP 3 125 042 B1**
(45) Veröffentlichungstag und Bekanntmachung des Hinweises auf die Patenterteilung: **17.04.2024**
(21) Anmeldenummer: 16001669.7
(22) Anmeldetag: 28.07.2016
(51) Int. Cl.: G03F 7/00, B82Y 10/00, B82Y 40/00

(54) **PRÄGESTEMPEL FÜR NANOPRÄGELITHOGRAPHIE**
MOLD FOR NANOIMPRINT LITHOGRAPHY
MOULE POUR LITHOGRAPHIE PAR NANO-IMPRESSION

(30) Priorität: 31.07.2015 DE 102015009982
(43) Veröffentlichungstag der Anmeldung: 01.02.2017
(73) Patentinhaber: Giesecke+Devrient Currency Technology GmbH, 81677 München (DE)
(72) Erfinder: Scherer, Maik Rudolf Johann, 82491 Grainau (DE)
(74) Vertreter: Giesecke+Devrient IP

(56) Entgegenhaltungen:
- EP-A1- 2 752 867
- JP-A- 2011 001 520
- US-A1- 2012 112 387
- US-A1- 2012 301 608

## Beschreibung

Die Erfindung betrifft einen Prägestempel für den Einsatz in der gepulsten Nanoprägelithographie, mit einem Heizelement und einer auf dem Heizelement angeordneten Prägestruktur, die mit einem einzuprägenden Prägeprofil versehen ist, wobei das Heizelement eine elektrisch leitende Schicht zum gepulsten Aufheizen der Prägestruktur aufweist, und wobei die der Prägestruktur zugewandte Seite des Heizelements eine elektrische Isolationsschicht aufweist.

Die Erfindung betrifft auch ein Verfahren zum Herstellen eines derartigen Prägestempels. Die Nanoprägelithografie (engl: nano imprint lithography, kurz NIL) ist ein kostengünstiges Verfahren zum Prägen nanostrukturierter Materialien mit hohem Durchsatz und hoher Präzision durch mechanische Verformung. Bei der Nanoprägelithografie wird ein nanostrukturierter Prägestempel in Kontakt mit einem thermoplastischen Material gebracht und auf eine Temperatur oberhalb der Glasübergangstemperatur des Thermoplasten erhitzt. Durch seine niedrige Viskosität fließt das thermoplastische Material in die Vertiefungen des Prägestempels und erzeugt dadurch die gewünschten Oberflächenstrukturen im thermoplastischen Material. Nach dem Abkühlen auf eine Temperatur unterhalb der Glasübergangstemperatur kann das geprägte Material entformt werden und es verbleibt das gewünschte nanostrukturierte Oberflächenrelief im thermoplastischen Material. Wird dabei bei zu hohen Temperaturen entformt, kann es zu Anhaftungen des Thermoplasten am Prägestempel und zu Deformationen der geprägten Oberflächenstrukturen kommen. Sollen auf einer größeren Fläche mehrere benachbarte Oberflächenstrukturen erzeugt werden, ist es auch wichtig, den Wärmeeintrag in den Thermoplasten möglichst gering zu halten, um das Aufschmelzen bereits geprägter Bereiche zu verhindern.

In diesem Zusammenhang sind in der Druckschrift EP 1 639 411 B1 Prägestempel vorgeschlagen worden, die durch kurze Strompulse schnell aufgeheizt werden können. Dabei besteht der Prägestempel beispielsweise aus einem Silicon-on-Insulator-Wafer, bei dem eine dotierte Siliziumschicht als Heizwiderstand dient. Als Prägeprofil wird das Negativ der zu prägenden Oberflächenstruktur direkt in die dotierte Siliziumschicht eingeätzt, vorzugsweise durch reaktives Ionenätzen. Auch aus der Druckschrift US 2012/0112387 A1 ist eine Prägeform für die thermische Nanoimprint-Lithographie mit einer Widerstandsheizeinrichtung bekannt.

Die Herstellung von Prägestempeln für den Einsatz in der gepulsten Nanoprägelithographie ist derzeit kosten- und zeitintensiv. Beispielsweise ist die in der EP 1 639 411 B1 beschriebene Herstellung mittels lithographischer Prozessschritte und reaktivem Ionenätzen aufwendig und fehleranfällig. Bei einem Fehler oder einer Beschädigung des Prägeprofils ist der Prägestempel unbrauchbar und muss ersetzt werden.

Ausgehend davon liegt der Erfindung die Aufgabe zugrunde, die Nachteile des Standes der Technik zu vermeiden und insbesondere, einen Prägestempel der eingangs genannten Art anzugeben, der einfacher und kostengünstiger als herkömmliche Prägestempel herstellbar ist und der idealerweise vielseitig und variabel eingesetzt werden kann.

Diese Aufgabe wird durch die Merkmale der unabhängigen Ansprüche gelöst. Weiterbildungen der Erfindung sind Gegenstand der Unteransprüche.

Gemäß der Erfindung ist bei einem gattungsgemäßen Prägestempel vorgesehen, dass die Prägestruktur im Bereich der elektrischen Isolationsschicht lösbar mit dem Heizelement verbunden ist, und das Heizelement ein erhöhtes Podest aufweist und die Prägestruktur mit dem einzuprägenden Prägeprofil lösbar über das Podest gespannt ist.

Die lösbare Verbindung von Heizelement und Prägestruktur bietet eine Reihe von Vorteilen. Zum einen wird die Herstellung des Prägestempels stark vereinfacht, da die Prägestruktur nicht auf der Oberseite des Heizelements erzeugt werden muss, sondern in einem speziell angepassten Verfahren erfolgen kann. Auch hat ein Fehler bei der Herstellung oder eine Beschädigung der Prägestruktur keinerlei Einfluss auf das Heizelement. Die Herstellung der Prägestruktur und die Herstellung des Heizelements können sogar in verschiedenen Produktionsstätten erfolgen, was insbesondere bei der Herstellung von Prägestempeln für den Sicherheitsdruck von Vorteil ist, da dann nur die Herstellung der Prägestruktur unter strengen Sicherheitsvorkehrungen erfolgen muss, während die Herstellung der unter Sicherheitsaspekten unkritischen Heizelemente ohne besondere Sicherheitsmaßnahmen erfolgen oder ausgelagert werden kann. Die elektrische Isolationsschicht stellt dabei sicher, dass der Heizstrom nicht in die Prägestruktur gelangt.

Das Heizelement des Prägestempels weist ein erhöhtes Podest auf, wobei die Prägestruktur mit dem Prägeprofil lösbar über das Podest gespannt ist. Das Podest ist dabei vorteilhaft in der elektrisch leitenden Schicht des Heizelements ausgebildet. Es weist bevorzugt eine Höhe zwischen 5 µm und 300 µm auf. Durch das erhöhte Podest kann die aktiv prägende Fläche der Prägestruktur auf den Bereich des einzuprägenden Prägeprofils beschränkt werden. Darüber hinaus kann dadurch bei einem Step & Repeat-Prozess das Überprägen bereits geprägter Bereiche verhindert werden.

In einer vorteilhaften Ausgestaltung ist die Prägestruktur durch ein hitzestabiles Klebeband lösbar mit dem Heizelement verbunden. Dies erlaubt eine sichere und dennoch leicht lösbare Verbindung von Prägestruktur und Heizelement.

In einer weiteren vorteilhaften Ausgestaltung ist die Prägestruktur durch eine Lötschicht zwischen Prägestruktur und elektrischer Isolationsschicht lösbar mit dem Heizelement verbunden. Als Material für die Lötschicht kommen Metalle oder Legierungen mit geeigneten Schmelzpunkten infrage, insbesondere mit Schmelzpunkten zwischen 500 °C und 1000 °C. Das Lötmaterial wird dazu als dünne Schicht auf die Rückseite der Prägestruktur oder auf die elektrische Isolationsschicht des Heizelementes aufgebracht. Durch Aufheizen des Prägestempels und der Prägestruktur über den Schmelzpunkt des Lötmaterials hinaus und gegebenenfalls unter Druck kann die Prägestruktur auf das Heizelement aufgelötet werden. Das Lötmaterial garantiert einen guten Wärmetransport zwischen Heizelement und Prägestruktur. Durch Aufheizen über den Schmelzpunkt des Lötmaterials hinaus lässt sich die Prägestruktur wieder vom Heizelement lösen.

Das Heizelement weist mit Vorteil ein wärmeisolierendes Substrat auf, auf dem die elektrisch leitende Schicht angeordnet ist. Das wärmeisolierende Substrat kann beispielsweise durch eine oxidische Keramik, ein Metalloxid, oder eine Siliziumbasisschicht eines Silicon-on-Insulator-(SOI)-Elements gebildet sein. Die Wärmeleitfähigkeit des wärmeisolierenden Substrats liegt mit Vorteil unterhalb von 5 W/(m K), insbesondere unterhalb von 1 W/(m K).

Vorzugsweise ist die elektrisch leitende Schicht des Heizelements durch eine Metallschicht (z.B. Platin oder Iridium) oder eine dotierte Halbleiterschicht gebildet, insbesondere durch eine dotierte, äußere Siliziumschicht eines SOI-Elements. Der elektrische Widerstand der elektrisch leitenden Schicht erzeugt während des kurzen Strompulses die zum Aufheizen der Prägestruktur und insbesondere des Prägeprofils erforderliche Wärme. Der lokale Widerstand der elektrisch leitenden Schicht muss nicht konstant sein, vielmehr kann die elektrisch leitende Schicht in dem Bereich, in dem das Prägeprofil angeordnet wird, einen erhöhten Widerstand aufweisen, um die Heizleistung auf diesen Bereich zu fokussieren. Ein erhöhter Widerstand kann beispielsweise durch eine lokale Verringerung der Querschnittsfläche bzw. der Schichtdicke einer Metall- oder Halbleiterschicht oder durch eine lokal geringere Dotierung einer Halbleiterschicht erzeugt werden.

Die Prägestruktur ist bevorzugt aus einem elektrisch leitfähigen Material, vorzugsweise aus einem Metall, insbesondere aus Nickel, Kobalt, Chrom oder Kupfer oder einer Metalllegierung gebildet. Die Dicke der Prägestruktur liegt vorteilhaft zwischen 5 µm und 150 µm, insbesondere zwischen 5 µm und 50 µm. Die Oberfläche der Prägestruktur ist zweckmäßig zumindest im Bereich des Prägeprofils mit einer Antihaftschicht versehen. Bei der Antihaftschicht handelt es sich typischerweise um eine monomolekulare Schicht aus unpolaren Kohlenwasserstoffketten oder Fluorkohlenwasserstoffen, die mittels einer reaktiven Gruppe kovalent an der Metalloberfläche verankert werden.

Die elektrische Isolationsschicht ist bevorzugt durch eine Schicht eines anorganischen Dielektrikums, wie etwa Al₂O₃, SiO₂ oder HfO₂, gebildet, oder auch durch eine dünne SiO₂-Schicht einer Siliziumschicht. Letztere kann beispielsweise durch thermische Oxidation der Siliziumschicht, beispielsweise der dotierten, äußeren Siliziumschicht eines SOI-Elements erzeugt werden. Die elektrische Isolationsschicht ist zweckmäßig so dünn ausgebildet, dass sie den Wärmetransport der in der elektrisch leitenden Schicht erzeugten Wärme zum Prägeprofil nicht wesentlich behindert. Eine gute elektrische Isolation trotz geringer Schichtdicke kann insbesondere durch möglichst porenfreie Schichten aus einem Material mit hoher Durchschlagfestigkeit oberhalb von 5 kV/mm und hohem spezifischem Widerstand oberhalb von 1 Gigaohm*cm erreicht werden. Besonders hochwertige Isolationsbeschichtungen lassen sich aus anorganischen Dielektrika mittels Atomlagenabscheidung (engl: atomic layer deposition, kurz ALD) herstellen.

Die Erfindung enthält auch ein Verfahren zum Herstellen eines Prägestempels der oben beschriebenen Art, bei dem
- ein Heizelement mit einer elektrisch leitenden Schicht zum gepulsten Aufheizen einer Prägestruktur des Prägestempels und mit einer elektrischen Isolationsschicht auf der der Prägestruktur zugewandten Seite des Heizelements erzeugt wird,
- eine Prägestruktur mit einem einzuprägenden Prägeprofil erzeugt wird, und
- die Prägestruktur im Bereich der elektrischen Isolationsschicht lösbar mit dem Heizelement verbunden wird.

Vorzugsweise wird die Prägestruktur dabei durch ein hitzestabiles Klebeband lösbar mit dem Heizelement verbunden. Nach einer ebenfalls vorteilhaften Verfahrensvariante wird die Prägestruktur durch Anordnung einer Lötschicht zwischen Prägestruktur und elektrischer Isolationsschicht lösbar mit dem Heizelement verbunden.

Erfindungsgemäß wird das Heizelement mit einem erhöhten Podest erzeugt und die Prägestruktur wird so mit dem Heizelement verbunden, dass das einzuprägende Prägeprofil über das Podest gespannt ist.

Die Prägestruktur wird dabei mit Vorteil durch galvanische Abscheidung erzeugt. Durch eine galvanische Vervielfältigung kann ohne weiteres eine große Zahl gleichartiger Prägestrukturen mit den gewünschten Prägeprofilen hergestellt werden.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Fig. 1: einen Prägestempel für die gepulste Nanoprägelithographie nach einem Ausführungsbeispiel der Erfindung,
- Fig. 2: das Heizelement des Prägestempels der Fig. 1,
- Fig. 3: die Prägematrize des Prägestempels der Fig. 1, und
- Fig. 4: in (a) bis (c) schematisch das Vorgehen bei der Nanoprägelithographie mit Hilfe des Prägestempels der Fig. 1.

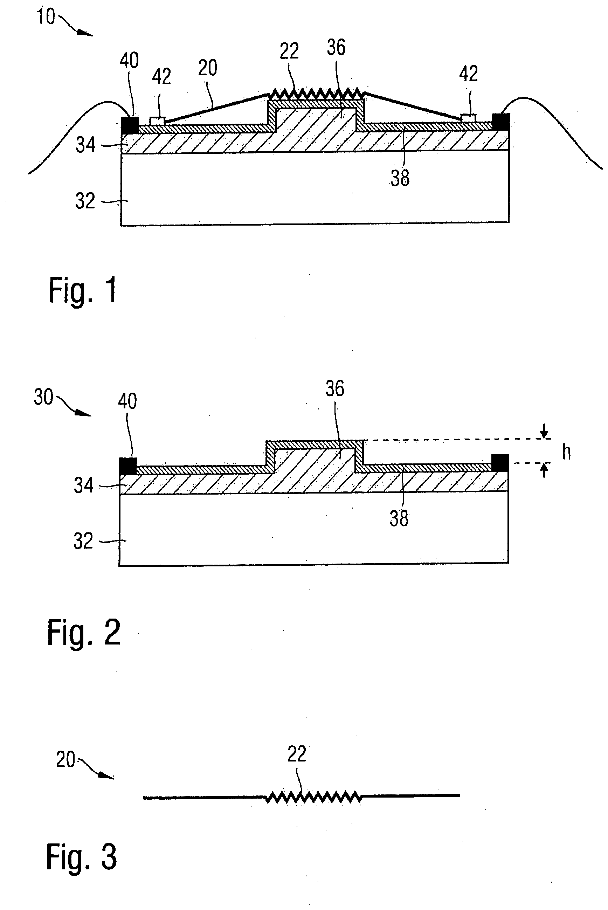

Die Figuren 1 bis 3 zeigen einen erfindungsgemäßen Prägestempel 10, der in einem gepulsten Nanoprägelithographie-Verfahren zum Einsatz kommt. Der Prägestempel 10 umfasst ein Heizelement 30 und eine lösbar mit dem Heizelement verbundene, metallische Prägematrize 20 mit einem Prägeprofil 22, wobei das Heizelement in Fig. 2 und die Prägematrize in Fig. 3 jeweils separat dargestellt sind.

Mit Bezug zunächst auf Fig. 2 ist das Heizelement 30 des Prägestempels 10 im Ausführungsbeispiel aus einem SOI-(Silicon-on-Insulator)-Wafer gebildet. Die Siliziumbasisschicht 32 des Wafers stellt dabei ein wärmeisolierendes Substrat des Heizelements 30 dar. Durch eine selbst nicht dargestellte dünne Isolatorschicht von der Siliziumbasisschicht 32 getrennt, liegt an der Oberseite des Wafers eine elektrisch leitende, hochdotierte Siliziumschicht 34 vor, die als elektrisch leitende, aber dennoch widerstandsbehaftete Schicht zur Heizung des Prägeprofils 22 der Prägematrize 20 dient.

Die elektrisch leitende, hochdotierte Siliziumschicht 34 wurde dabei lithographisch strukturiert, um ein Podest 36 freizulegen, das eine Höhe h zwischen 5 µm und 300 µm, im Ausführungsbeispiel von etwa 100 µm aufweist. Die laterale Abmessung des Podests 36 entspricht der Größe des gewünschten Prägeprofils 22 (Fig. 3).

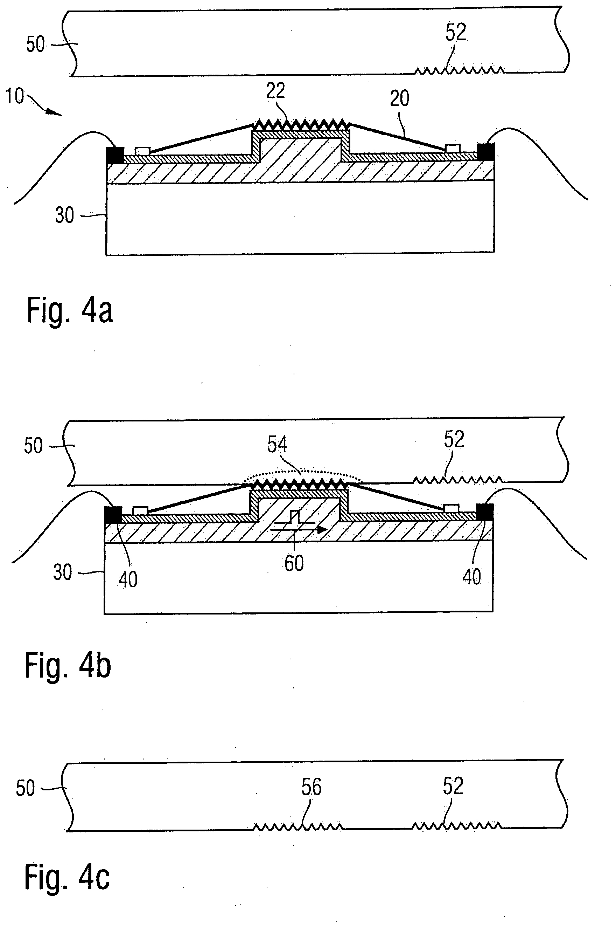

Über zwei ohmsche Kontakte 40 kann der elektrisch leitenden, hochdotierten Siliziumschicht 34 ein gepulster Heizstrom eingeprägt werden, der aufgrund des Widerstands der Siliziumschicht zu einem raschen Aufheizen des Prägeprofils 22 führt, wie weiter unten im Zusammenhang mit Fig. 4 genauer beschrieben.

An seiner Oberseite ist das Heizelement 30 mit einer elektrischen Isolationsschicht 38 versehen, die die Prägematrize 20 elektrisch von der elektrisch leitenden, hochdotierten Siliziumschicht 34 trennt. Die elektrische Isolationsschicht 38 kann grundsätzlich durch eine aufgebrachte Schicht eines anorganischen Dielektrikums, wie etwa Al₂O₃, SiO₂ oder HfO₂, gebildet sein, ist aber im Ausführungsbeispiel durch eine durch thermische Oxidation des Siliziums der elektrisch eitenden, hochdotierten Siliziumschicht 34 erzeugte dünne SiO₂-Schicht gebildet. In jedem Fall ist die elektrische Isolationsschicht 38 so dünn ausgebildet, dass sie den Wärmetransport der in der elektrisch leitenden, hochdotierten Siliziumschicht 34 erzeugten jouleschen Wärme zum Prägeprofil 22 nicht wesentlich behindert. Um trotz der geringen Schichtdicke eine gute elektrische Isolation zu erzielen, ist die Isolationsschicht möglichst porenfrei ausgebildet und weist eine hohe Durchschlagsfestigkeit und einen hohen spezifischen Widerstand auf.

Figur 3 zeigt die metallische Prägematrize 20 mit dem gewünschten Prägeprofil 22, das insbesondere ein nanostrukturiertes Prägeprofil mit Strukturgrößen bis herab zu einigen zehn Nanometern darstellen kann. Die Prägematrize 20 wird vorteilhaft galvanisch hergestellt, da durch eine galvanische Vervielfältigung ohne weiteres eine große Zahl gleichartiger Prägematrizen hergestellt werden kann. Die Prägematrizen der Erfindung weisen in der Regel eine Dicke zwischen 5 µm und 150 µm, im Ausführungsbeispiel von 20 µm auf. Die Prägematrize 20 der Fig. 3 besteht aus Nickel. Geeignete Prägematrizen können jedoch auch aus beliebigen anderen, galvanisch herstellbaren Materialien bestehen.

Ein wesentliches Merkmal der vorliegenden Erfindung besteht darin, dass die Prägematrize 20 im Bereich der elektrischen Isolationsschicht 38 lösbar mit dem Heizelement 30 verbunden ist, beispielsweise mit Hilfe eines hitzebeständigen Klebebands 42 oder einer (hier nicht dargestellten) zwischen Prägematrize 20 und elektrischer Isolationsschicht 38 vollflächig angeordneten wieder aufschmelzbaren Lötschicht.

Figur 1 zeigt den Prägestempel 10 mit dem Heizelement 30 der Fig. 2 und der Prägematrize 20 der Fig. 3, welche so über das Podest 36 gespannt ist, dass das Prägeprofil 22 auf der Oberfläche des Podests 36 fixiert ist. Die Prägematrize 20 und das Heizelement 30 bilden somit im Prägestempel 10 keine untrennbare Einheit, sondern können durch Abziehen des hitzebeständigen Klebebands 42 auf einfache Weise getrennt und separat ausgetauscht werden. Entsprechend kann eine aufgelötete Prägematrize durch Aufheizen des Prägestempels über den Schmelzpunkt des Lötmaterials hinaus nach dem Aufschmelzen des Lötmaterials von dem Heizelement getrennt werden.

Durch die lösbare Verbindung von Heizelement 30 und Prägematrize 20 wird die Herstellung des Prägestempels 10 stark vereinfacht, da die hochaufgelöste Prägestruktur nicht auf der Oberseite des Heizelements erzeugt werden muss, sondern in einem speziell angepassten Verfahren erfolgen kann. Auch kann die Herstellung der Prägematrizen 20 und die Herstellung der Heizelemente 30 an getrennten Orten erfolgen, was insbesondere bei der Herstellung von Prägestempeln für den Sicherheitsdruck von Vorteil ist. Weiter wird bei herkömmlichen Prägestempeln bei einer defekten Prägestruktur oder einem defekten Heizelement der gesamte Prägestempel unbrauchbar, während bei einem erfindungsgemäßen Prägestempel nur das jeweils defekte Teil, wegen der höheren Beanspruchung in der Regel die Prägestruktur, ausgetauscht werden muss. Es ist natürlich auch möglich, dasselbe Heizelement mit Prägematrizen mit unterschiedlichen Designs zu kombinieren und die Heizelemente somit effektiver und vielseitiger zu nutzen.

Figur 4 illustriert schematisch das Vorgehen bei der Nanoprägelithographie mit Hilfe eines erfindungsgemäßen Prägestempels 10. Mit Bezug auf Fig. 4(a) enthält das Prägeprofil 22 der Prägematrize 20 das Negativ der gewünschten, in ein thermoplastisches Material 50 einzuprägenden Oberflächenstruktur. Das thermoplastische Material 50 kann bereits eine zuvor eingeprägte Oberflächenstruktur 52 enthalten, etwa weil in einem Step & Repeat-Prozess eine Mehrzahl von Oberflächenstrukturen in dasselbe thermoplastische Material 50 eingeprägt werden. Dabei ist es wesentlich, dass die bereits vorhandene Oberflächenstruktur 52 durch einen nachfolgenden Prägeschritt nicht zerstört oder degradiert wird.

In dem in Fig. 4(b) gezeigten Prägeschritt werden nun das thermoplastische Material 50 und der Prägestempel 10 in Kontakt gebracht und gegeneinander gedrückt. Dann wird die elektrisch leitende, hochdotierte Siliziumschicht 34 einem kurzen Strompuls 60 ausgesetzt, wobei der elektrische Widerstand der elektrisch leitenden, hochdotierten Siliziumschicht 34 als Heizwiderstand wirkt, der ein schnelles Aufheizen des Prägeprofils 22 und dadurch auch ein lokales Aufheizen des thermoplastischen Materials 50 in einem Teilbereich 54 auf eine Temperatur oberhalb der Glasübergangstemperatur bewirkt. Da durch den kurzen Strompuls 60 nur wenige Wärmeenergie in den Prägestempel 10 und das thermoplastische Material 50 eingebracht wird, wird einerseits die bereits vorhandene Oberflächenstruktur 52 nicht beeinträchtigt, und kühlen andererseits sowohl der Prägestempel als auch das thermoplastische Material 50 selbstständig innerhalb kürzester Zeit wieder unter die Glasübergangstemperatur ab, so dass das thermoplastische Material 50 rasch wieder entformt werden kann. Figur 4(c) zeigt das thermoplastische Material 50 nach dem Prägeschritt der Fig. 4(b) mit der zusätzlich eingeprägten Oberflächenstruktur 56. Es versteht sich, dass der Prägeschritt wiederholt werden kann, um weitere Oberflächenstrukturen in dem thermoplastischen Material 50 zu erzeugen.

Die Pulsdauer des eingeprägten Strompulses 60 beträgt nur einen Sekundenbruchteil und liegt typischerweise unterhalb einer Millisekunde.

Die Vorteile der gepulsten Nanoprägelithographie im Vergleich zu herkömmlichem Heißprägen mit einer konstanten Stempeltemperatur liegen insbesondere darin, dass durch den geringen Wärmeeintrag in das thermoplastische Material 50 bereits geprägte Bereiche, wie etwa die Oberflächenstruktur 52, nicht aufgeschmolzen werden. Auch wird das thermoplastische Material nicht verformt, es bilden sich keine Wülste am Rand der Prägung, der Stempel sinkt nicht in das thermoplastische Material ein und es wird keine thermische Degradation des Thermoplasten beobachtet. Die hohen erreichbaren Stempeltemperaturen gewährleisten zudem eine niedrige Viskosität und damit gute Fließeigenschaften des thermoplastischen Materials.

### Bezugszeichenliste

- 10: Prägestempel
- 20: Prägematrize
- 22: Prägeprofil
- 30: Heizelement
- 32: Siliziumbasisschicht
- 34: elektrisch leitende, hochdotierte Siliziumschicht
- 36: Podest
- 38: elektrische Isolationsschicht
- 40: ohmsche Kontakte
- 42: hitzebeständiges Klebeband
- 50: thermoplastisches Material
- 52,56: Oberflächenstrukturen
- 54: Teilbereich
- 60: Strompuls

## Patentansprüche

1. Prägestempel (10) für die gepulste Nanoprägelithographie, mit einem Heizelement (30) und einer auf dem Heizelement (30) angeordneten Prägestruktur, die mit einem einzuprägenden Prägeprofil (22) versehen ist, wobei das Heizelement (30) eine elektrisch leitende Schicht zum gepulsten Aufheizen der Prägestruktur aufweist, und wobei die der Prägestruktur zugewandte Seite des Heizelements (30) eine elektrische Isolationsschicht (38) aufweist, **dadurch gekennzeichnet, dass** die Prägestruktur im Bereich der elektrischen Isolationsschicht (38) lösbar mit dem Heizelement (30) verbunden ist, wobei das Heizelement (30) ein erhöhtes Podest (36) aufweist und die Prägestruktur mit dem einzuprägenden Prägeprofil (22) lösbar über das Podest (36) gespannt ist.

2. Prägestempel (10) nach Anspruch 1, wobei das Podest (36) in der elektrisch leitenden Schicht des Heizelements (30) ausgebildet ist.

3. Prägestempel (10) nach Anspruch 2, wobei das Podest (36) eine Höhe zwischen 5 µm und 300 µm aufweist.

4. Prägestempel (10) nach einem der Ansprüche 1 bis 3, wobei die Prägestruktur durch ein hitzestabiles Klebeband lösbar mit dem Heizelement (30) verbunden ist oder die Prägestruktur durch eine zwischen der Prägestruktur und der elektrischen Isolationsschicht (38) angeordnete Lötschicht lösbar mit dem Heizelement (30) verbunden ist.

5. Prägestempel (10) nach einem der Ansprüche 1 bis 4, wobei das Heizelement (30) ein wärmeisolierendes Substrat aufweist, auf dem die elektrisch leitende Schicht angeordnet ist.

6. Prägestempel (10) nach einem der Ansprüche 1 bis 5, wobei die elektrisch leitende Schicht des Heizelements (30) durch eine Metallschicht, insbesondere durch eine Schicht aus Platin oder Iridium, oder eine dotierte Halbleiterschicht gebildet ist, insbesondere durch eine dotierte, äußere Siliziumschicht eines SOI-(Silicon-on-Insulator)-Elements.

7. Prägestempel (10) nach einem der Ansprüche 1 bis 6, wobei die Prägestruktur aus einem elektrisch leitfähigen Material, vorzugsweise aus einem Metall, insbesondere aus Nickel gebildet ist.

8. Prägestempel (10) nach einem der Ansprüche 1 bis 7, wobei die Prägestruktur eine Dicke zwischen 5 µm und 150 µm, vorzugsweise zwischen 5 µm und 50 µm aufweist.

9. Prägestempel (10) nach einem der Ansprüche 1 bis 8, wobei die Oberfläche der Prägestruktur zumindest im Bereich des Prägeprofils (22) mit einer Antihaftschicht versehen ist.

10. Prägestempel (10) nach einem der Ansprüche 1 bis 9, wobei die elektrische Isolationsschicht (38) durch eine Schicht eines anorganischen Dielektrikums, wie etwa Al₂O₃, SiO₂ oder HfO₂, oder durch eine durch thermische Oxidation einer Siliziumschicht, insbesondere der dotierten, äußeren Siliziumschicht eines SOI-(Silicon-on-Insulator)-Elements erzeugte dünne SiO₂-Schicht gebildet ist.

11. Verfahren zum Herstellen eines Prägestempels (10) nach einem der Ansprüche 1 bis 10, bei dem
- ein Heizelement (30) mit einer elektrisch leitenden Schicht zum gepulsten Aufheizen einer Prägestruktur des Prägestempels (10) und mit einer elektrischen Isolationsschicht (38) auf der der Prägestruktur zugewandten Seite des Heizelements (30) erzeugt wird,
- eine Prägestruktur mit einem einzuprägenden Prägeprofil (22) erzeugt wird, und
- die Prägestruktur im Bereich der elektrischen Isolationsschicht (38) lösbar mit dem Heizelement (30) verbunden wird, wobei das Heizelement (30) mit einem erhöhten Podest (36) erzeugt wird, und die Prägestruktur so mit dem Heizelement (30) verbunden wird, dass das einzuprägende Prägeprofil (22) über das Podest (36) gespannt ist.

12. Verfahren nach Anspruch 11, wobei die Prägestruktur durch ein hitzestabiles Klebeband lösbar mit dem Heizelement (30) verbunden wird oder die Prägestruktur durch Anordnung einer Lötschicht zwischen der Prägestruktur und der elektrischen Isolationsschicht (38) lösbar mit dem Heizelement (30) verbunden wird.

13. Verfahren nach wenigstens einem der Ansprüche 11 bis 12, wobei die Prägestruktur durch galvanische Abscheidung erzeugt wird.

## Claims

1. Embossing die (10) for pulsed nanoimprint lithography, comprising a heating element (30) and an embossing structure, which is arranged on the heating element (30) and is provided with an embossing profile (22) to be embossed, wherein the heating element (30) comprises an electrically conductive layer for pulsed heating of the embossing structure, and wherein that side of the heating element (30) that faces towards the embossing structure comprises an electrical insulation layer (38), **characterized in that** the embossing structure is detachably connected to the heating element (30) in the region of the electrical insulation layer (38), wherein the heating element (30) has an elevated pedestal (36) and the embossing structure with the embossing profile (22) to be embossed is detachably clamped via the pedestal (36).

2. Embossing die (10) according to Claim 1, wherein the pedestal (36) is formed in the electrically conductive layer of the heating element (30).

3. Embossing die (10) according to Claim 2, wherein the pedestal (36) has a height of between 5 um and 300 µm.

4. Embossing die (10) according to one of Claims 1 to 3, wherein the embossing structure is detachably connected to the heating element (30) by an thermally stable adhesive tape or the embossing structure is detachably connected to the heating element (30) by a solder layer arranged between the embossing structure and the electrical insulation layer (38).

5. Embossing die (10) according to one of Claims 1 to 4, wherein the heating element (30) comprises a thermally insulating substrate, on which the electrically conductive layer is arranged.

6. Embossing die (10) according to one of Claims 1 to 5, wherein the electrically conductive layer of the heating element (30) is formed by a metal layer, in particular by a layer of platinum or iridium, or a doped semiconductor layer, in particular by a doped, external silicon layer of an SOI (silicon-on-insulator) element.

7. Embossing die (10) according to one of Claims 1 to 6, wherein the embossing structure is made of an electrically conductive material, preferably a metal, in particular nickel.

8. Embossing die (10) according to one of Claims 1 to 7, wherein the embossing structure has a thickness of between 5 um and 150 µm, preferably between 5 um and 50 µm.

9. Embossing die (10) according to one of Claims 1 to 8, wherein the surface of the embossing structure is provided with an anti-adhesion layer at least in the region of the embossing profile (22).

10. Embossing die (10) according to one of Claims 1 to 9, wherein the electrical insulation layer (38) is formed by a layer of an inorganic dielectric, such as Al₂O₃, SiO₂ or HfO₂, or by a thin SiO₂ layer created by thermal oxidation of a silicon layer, in particular the doped, external silicon layer of an SOI (silicon-on-insulator) element.

11. Method for producing an embossing die (10) according to one of Claims 1 to 10, in which
- a heating element (30) comprising an electrically conductive layer for pulsed heating of an embossing structure of the embossing die (10) and comprising an electrical insulation layer (38) on that side of the heating element (30) that faces towards the embossing structure is created,
- an embossing structure comprising an embossing profile (22) to be embossed is created, and
- the embossing structure is detachably connected to the heating element (30) in the region of the electrical insulation layer (38), wherein the heating element (30) is created with an elevated pedestal (36), and the embossing structure is connected to the heating element (30) such that the embossing profile (22) to be embossed is clamped via the pedestal (36).

12. Method according to Claim 11, wherein the embossing structure is detachably connected to the heating element (30) by a thermally stable adhesive tape or the embossing structure is detachably connected to the heating element (30) by arranging a solder layer between the embossing structure and the electrical insulation layer (38).

13. Method according to at least one of Claims 11 to 12, wherein the embossing structure is created by electrodeposition.

## Revendications

1. Moule (10) destiné à la lithographie par nano-impression pulsée, ledit moule comprenant un élément chauffant (30) et une structure d'impression qui est disposée sur l'élément chauffant (30) et qui est pourvue d'un profil d'impression (22) à imprimer, l'élément chauffant (30) comportant une couche électriquement conductrice destinée à chauffer de manière pulsée la structure d'impression, et le côté de l'élément chauffant (30) qui est dirigé vers la structure d'impression comportant une couche d'isolation électrique (38), **caractérisé en ce que** la structure d'impression est reliée de manière amovible à l'élément chauffant (30) dans la zone de la couche d'isolation électrique (38), l'élément chauffant (30) comportant un socle surélevé (36) et la structure d'impression pourvue du profil d'impression (22) à imprimer étant serrée de manière amovible sur le socle (36) .

2. Moule (10) selon la revendication 1, le socle (36) étant formé dans la couche électriquement conductrice de l'élément chauffant (30).

3. Moule (10) selon la revendication 2, le socle (36) ayant une hauteur comprise entre 5 µm et 300 µm.

4. Moule (10) selon l'une des revendications 1 à 3, la structure d'impression étant reliée de manière amovible à l'élément chauffant (30) par un ruban adhésif thermostable ou la structure d'impression étant reliée de manière amovible à l'élément chauffant (30) par une couche de soudure disposée entre la structure d'impression et la couche d'isolation électrique (38).

5. Moule (10) selon l'une des revendications 1 à 4, l'élément chauffant (30) comportant un substrat thermo-isolant sur lequel la couche électriquement conductrice est disposée.

6. Moule (10) selon l'une des revendications 1 à 5, la couche électriquement conductrice de l'élément chauffant (30) étant formée par une couche métallique, en particulier par une couche de platine ou d'iridium, ou une couche de semi-conducteur dopée, en particulier une couche de silicium extérieure dopée d'un élément SOI (silicium sur isolant).

7. Moule (10) selon l'une des revendications 1 à 6, la structure d'impression étant formée d'un matériau électriquement conducteur, de préférence d'un métal, en particulier du nickel.

8. Moule (10) selon l'une des revendications 1 à 7, la structure d'impression ayant une épaisseur comprise entre 5 µm et 150 µm, de préférence entre 5 µm et 50 µm.

9. Moule (10) selon l'une des revendications 1 à 8, la surface de la structure d'impression étant dotée d'une couche antiadhésive au moins dans la zone du profil d'impression (22).

10. Moule (10) selon l'une des revendications 1 à 9, la couche d'isolation électrique (38) étant produite par une couche d'un diélectrique minéral, tel que Al₂O₃, SiO₂ ou HfO₂, ou par une mince couche de SiO₂ formée par oxydation thermique d'une couche de silicium, en particulier la couche de silicium extérieure dopée d'un élément SOI (silicium sur isolant).

11. Procédé de fabrication d'un moule (10) selon l'une des revendications 1 à 10, dans lequel
- un élément chauffant (30) est généré avec une couche électriquement conductrice destinée à chauffer de manière pulsée une structure d'impression du moule (10) et avec une couche d'isolation électrique (38) du côté de l'élément chauffant (30) qui est dirigé vers la structure d'impression,
- une structure d'impression est générée avec un profil d'impression (22) à imprimer, et
- la structure d'impression est reliée de manière amovible à l'élément chauffant (30) au niveau de la couche d'isolation électrique (38), l'élément chauffant (30) étant généré avec un socle surélevé (36) et la structure d'impression étant reliée à l'élément chauffant (30) de manière à serrer le profil d'impression (22) à imprimer sur le socle (36).

12. Procédé selon la revendication 11, la structure d'impression étant reliée de manière amovible à l'élément chauffant (30) par un ruban adhésif thermostable ou la structure d'impression étant reliée de manière amovible à l'élément chauffant (30) par disposition d'une couche de soudure entre la structure d'impression et la couche d'isolation électrique (38).

13. Procédé selon l'une au moins des revendications 11 à 12, la structure d'impression étant générée par dépôt galvanique.
